(19) **Europäisches Patentamt**

**European Patent Office**

**Office européen des brevets**

(11) **EP 0 281 141 B2**

(12) **NEW EUROPEAN PATENT SPECIFICATION**

(45) Date of publication and mention
of the opposition decision:
**28.06.2000 Bulletin 2000/26**

(45) Mention of the grant of the patent:
**25.10.1995 Bulletin 1995/43**

(51) Int. Cl.[7]: **C23C 14/34**

(21) Application number: **88103310.4**

(22) Date of filing: **03.03.1988**

(54) **Sputtering target**

Zerstäubungstarget

Cible de pulvérisation

(84) Designated Contracting States:
**DE FR GB**

(30) Priority: **06.03.1987 JP 4994087**

(43) Date of publication of application:
**07.09.1988 Bulletin 1988/36**

(73) Proprietor:
**KABUSHIKI KAISHA TOSHIBA
Kawasaki-shi, Kanagawa-ken 210-8572 (JP)**

(72) Inventors:
• **Fukusawa, Yoshiharu
c/o Kabushiki Kaisha Toshiba
Kawasaki-shi Kanagawa-ken (JP)**
• **Kawai, Mituo
c/o Kabushiki Kaisha Toshiba
Kawasaki-shi Kanagawa-ken (JP)**
• **Ishihara, Hideo
c/o Kabushiki Kaisha Toshiba
Kawasaki-shi Kanagawa-ken (JP)**
• **Yamanobe, Takashi
c/o Kabushiki Kaisha Toshiba
Kawasaki-shi Kanagawa-ken (JP)**

(74) Representative:
**Hansen, Bernd, Dr. Dipl.-Chem. et al
Hoffmann Eitle,
Patent- und Rechtsanwälte,
Postfach 81 04 20
81904 München (DE)**

(56) References cited:
**EP-A- 0 124 075**

• **JOURNAL OF VACUUM SCIENCE &
TECHNOLOGY A, vol. 3, no. 6, Second Series,
November-December 1985, pages 2152-2160,
New York, US ; N.Q. LAM et al.: "Elevated-
temperature sputtering of Ni-Au alloys : Surface
and subsurface composition modifications
measured by ion scattering spectroscopy"**
• **PATENT ABSTRACTS OF JAPAN, vol. 10, no. 302
(E-445)[2358], 15th October 1986 ; & JP-A-61 116
835**
• **PATENT ABSTRACTS OF JAPAN, vol. 10, no. 335
(C-384)[2391], 13th November 1986 ; & JP-A-61
139 637**
• **PATENT ABSTRACTS OF JAPAN, vol. 10, no. 49
(C-330)[2106], 26th February 1986 ; & JP-A-60
194 070**
• **PATENT ABSTRACTS OF JAPAN, vol. 10, no. 275
(E-438)[2331], 18th September 1986 ; & JP-A-61
97 823**
• **Erzmetall 38 (1985), Nr. 3, R. Eck et al., 129**
• **Pulvermetallurgie u.Sinterwerkstoffe 1982, 76-
103**

EP 0 281 141 B2

**Description**

BACKGROUND OF THE INVENTION

This invention relates to a method for preparing a sputtering target for use in formation of conductive thin films on semiconductor elements such as LSI chips and the like, and more particularly it relates to a method for preparing a sputtering target by which thickness of the thin films can be uniformed and by which scatter of sheet resistance in the thin films can be minimized.

For example, in manufacturing MOS type LSI gate electrodes, conductive thin films of a high-melting metal or the like are formed on the surfaces of LSI chips. As a means for forming the thin films, a sputtering process is usually applied.

In this case, a suitable sputtering target is selected from ones having various morphologies in compliance with a kind of thin films to be formed.

For example, when the thin film is formed with a single metal prepared by a melting process, there is used , as the sputtering target, a single block comprising a metal prepared by the melting process and having an optional shape such as a disk plate, a rectangular plate or the like on the whole, or a combined block having an optional shape such as a disk plate, a rectangular plate or the like on the whole and comprising a combination of plural wedge-shaped units composed of the above-mentioned metal.

Further, when the thin films are formed with an alloy such as a silicide, there is used, as the sputtering target, an alloy block comprising an alloy prepared by the melting process and having an optional shape such as a disk plate, a rectangular plate or the like on the whole, or a combined block having an optional shape such as a disk plate, a rectanguar plate or the like on the whole and comprising an optional combination of plural wedge-shaped or square bar-shaped single blocks composed of metals constituting the alloy prepared by the melting process.

Now, important requirements regarding a sputtering process are that film resistance (sheet resistance, $\Omega/\square$) of a formed thin film must not exceed a standard level and that scatter of sheet resistance values at certain positions on the surface of the formed thin film is narrow. Incidentally, the sheet resistance may be measured in accordance with a four-probe method.

Journal of Vacuum Science & Technology A, vol. 3, no. 6 Nov-Dec 1985, pages 2152-2160 discloses preparing a sputtering target from a Ni-6at.% Au alloy which is prepared in turn by arc melting and subsequent levitation melting in an induction furnace. The material is then rolled and rectangular specimens cut from it which are subjected to metallographically polishing and then solution annealing. The average size of the metal grains in the specimens obtained is 38 $\mu$m.

JP-A-61 116 835 discloses preparing a sputtering target formed from an alloy which is of high purity and possesses ultra-fine crystal grains. The alloy includes Si as an essential ingredient together with at least two metals which may be chosen from Mo, W, Ti or Ta. The Si exists within the alloy as a silicate having a grain diameter of 0.5-1 mm.

Erzmetall 38 1985 No 3 discloses the production of sputtering targets using powder-metallurgical techniques. Targets are formed from a compacted starting material which is then subjected to sintering at around 2000°C. The resulting sintered bodies are then subjected to deformation by processes such as forging or rolling followed by a heat treatment under vacuum in order to control the grain size to be less than 2000 grains/mm$^2$.

SUMMARY OF THE INVENTION

It is an object of this invention to provide a method for preparing a sputtering target by which its sheet resistance can be easily controlled below a standard level and by which thin films can be formed in which scatter of sheet resistance values measured at different positions on the surfaces thereof is narrow.

The inventors of the present application have researched on a sputtering target itself and a case of scatter of sheet resistance with the intention of achieving the above object, and as a result, they have found the following fact.

That is, this fact is that sheet resistance values of a formed thin film vary with thickness of this film. Therefore, in the case that the thickness of the thin film is different at optional positions thereon, the sheet resistance of the thin film is naturally scattered.

Furthermore, the investigation about the target has elucidated the following fact.

That is, this fact is that when a size and crystalline orientation of crystal grains of a metal or an alloy constituting the target are different, its amount sputtered therefrom is also different; in other words, that thickness of the thin film formed on an element disposed above the target is affected by the size and the crystalline orientation of the crystal grains of the metal or the alloy constituting the target. However, when the metal or the alloy constituting the target is single crystals, the crystalline orientation of the target is constant, and therefore the thickness of the formed thin film is not affected at all thereby.

In consequence, if the target is a disk-like or rectangular plate-like single block or alloy block prepared by a melting process and if crystal grains of the metal or the alloy constituting the block are different in size at certain positions in the block, sputtering amounts from the respective positions are not uniform and the thickness of the formed thin film also is different at certain positions thereof. Moreover, in the case that the target is a combined block, the thickness of the formed thin film differs variously at certain positions thereof owing to the influence of the scatter of the sputtering amount due to the different size of the crystal grains in each wedge-like or rod-like block, and further of the different sputtering amounts among the blocks.

On the basis of such knowledge, the present inventors have intensively researched on relations between the size of the crystal grains consitituting the target and the scatter of the sheet resistance values, and as a result, they have found that the smaller the size of the crystal grains is, the narrower the scatter of the sheet resistance values is, and above all, they have found that the target composed of a metal or an alloy in which the average size of the crystal grains is 1 mm or less and more than 1 $\mu$m, i.e., between 1 $\mu$m and 1 mm is extremely useful, and thus the target prepared by this invention has been developed.

That is, the invention provides a method for preparing a sputtering target for a semiconductor according to Claim 1.

BRIEF DESCRIPTION OF THE DRAWINGS

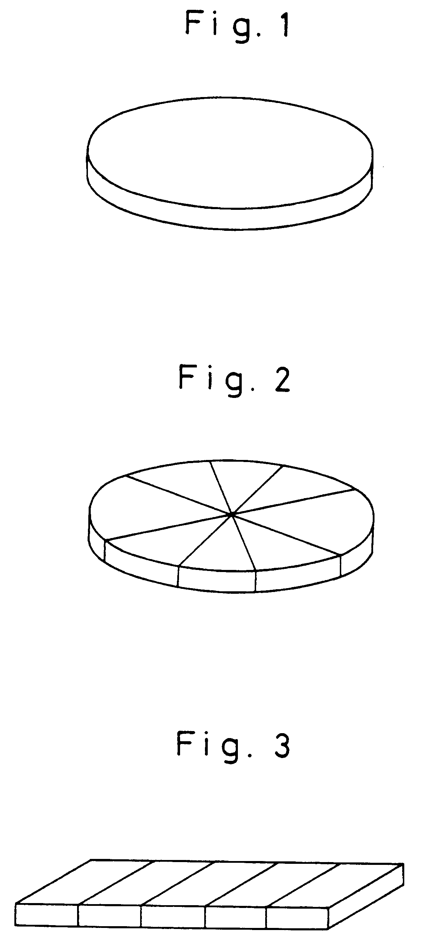

Figs. 1 to 3 are perspective views illustrating the whole shapes of sputtering targets prepared by this invention.

DESCRIPTION OF THE PREFERRED EMBODIMENTS

Examples of the metals constituting the sputtering target prepared by this invention include Mo, W, Ta, Nb, Ti, Ni, V and Cr, and examples of the alloys include various combinations of suitable ones of these metals.

The above-mentioned metal or alloy is prepared by the undermentioned procedure so that the average size of its crystal grains may be between 1 $\mu$m and 100 $\mu$m. On the other hand, when the average size of the crystal grains is less than 1 $\mu$m, the crystal grains themselves are sputtered, so that the scatter of the sheet resistance of the formed thin film is similarly worsened.

This average grain size can be determined by first counting the number of crystal grains in a visual field of a microscope, then calculating an average area of one crystal grain, and seeking an average diameter of the one crystal grain. The number (NA) of the crystal grains per unit area can be measured in the following manner:
In a microphotography showing metallic structure, the number (NW) of the crystal grains completely contained in a certain circle having an area A and the number (Ni) of the crystal grains partially contained therein are first counted. In this case, it is suitable that the sufficient number of the crystal grains (e.g., 30 grains or more) is present in the circle. Then, the total number (NT) of the crystal grains can be given by the following formula:

$$NT = NW + \frac{1}{2} Ni$$

Therefore, the formula of NA = NT/A can be derived. Then, the average area per the one crystal grain can be calculated by A/NA. A diameter of this average area is the desired average grain diameter.

The target can be manufactured as follows:
In the first place, a selected metal or alloy is melted in accordance with a vacuum melting process such as an EB(electron beam) melting process or an arc melting process. Then, the resulting melt is cooled to form an ingot having a predetermined shape, and the ingot is subjected to forging and rolling. Afterward, it is further molded into a single block having a predetermined shape such as a disk, a rectangular plate, a wedge or a square bar.

The size of the crystal grains of the metal or the alloy constituting the target can be adjusted by suitably selecting a working ratio in the steps of the forging and rolling. For example, in the case of an Mo target, a working ratio of 50% or more in the steps of from the ingot to the single block can suitably provide the desirable grain diameter.

The crystal grains in the single block are stretched in a longitudinal direction of the ingot by the forging and rolling, so that the grains take a fibrous structure. However, during the steps of the forming and rolling, strain is accumulated in the ingot, and recrystallized grains are formed by a subsequent heat treatment at a recrystallization temperature or higher, with this strain functioning as a nucleus. Consequently, the recrystallized grains are present as fine crystal grains in the ingot.

In the last place, the worked single block is subjected to a heat treatment at its recrystallization temperature or higher in order to obtain the desired target of the single block.

The thus manufactured rectangular plate-like single block or disk-like single block as shown in Fig. 1 may be directly mounted in a sputtering apparatus. In the case of the wedge-like or square bar-like single blocks, they may be combined suitably so as to prepare such a disk-like combined block as shown in Fig. 2 or such a square rod-like combined block as shown in Fig. 3. Then, the combined block can be similarly mounted in the sputtering apparatus.

Example 1 and Comparative Examples 1 to 3

An Mo sintered body was melted by an EB melting process, and the resulting melt was worked to prepare 4 piece of Mo ingots. Then, the respective ingots were subjected to forging and rolling in different working ratios, and a recrystallization heat treatment was then carried out to prepare disk-like targets having different average size of the crystal grains. Working ratios were about 90% in Example 1, about 70% in Comparative Example 1, about 45% in Comparative Example 2 and about 30% in Comparative Example 3.

These targets were used, and Mo thin films having a thickness of 300 nm (3,000 Å) were formed on Si wafers having a diameter of 13 cm (5 inches), thereby preparing 350 sheets of LSI chips. For all of the thus formed thin films, sheet resistance was measured, and its average value was sought. In addition, a yield of the LSI chips was calculated.

Further, from a maximum value, a minimum value and the average value of the sheet resistance, scatter of the sheet resistance in each thin film was calculated by using the following formula:

$$\frac{\text{maximum value - minimum value}}{\text{average value}} \times 100\ (\%)$$

These results are together set forth in the table 1.

Table 1

|  | Working ratio (%) | Average size of crystal grains (mm) | Sheet resistance ($\Omega/\square$) | | Yield of LSI chips (%) |
|---|---|---|---|---|---|
|  |  |  | Average ($\Omega/\square$) | Scatter (%) |  |
| Example 1 | about 90 | 0.08 | 2.7 | 8.5 | 98 |
| Comparative Example 1 | about 70 | 0.5 | 2.8 | 16 | 92 |
| Comparative Example 2 | about 45 | 2 | 3.7 | 20.8 | 87 |
| Comparative Example 3 | about 30 | 15 | 5.0 | 32 | 84 |

As is apparent from the above explanation, the sputtering target prepared by this invention can decrease scatter of sheet resistance of formed thin films, so that LSI chips can be manufactured in a high yield. Therefore, it is fair to say that the sputtering target prepared by this invention can possess great industrial values.

**Claims**

1.    A method for preparing a sputtering target for a semiconductor comprising at least one block composed of a single metal or alloy in which the average size of the crystal grains is 1-100 $\mu$m, comprising the steps of:

   melting the metal or the alloy by vacuum melting;
   cooling the melt to form an ingot;
   forging, rolling and molding the ingot to form it into a target; and
   subjecting the target to a re-crystallization heat treatment to obtain the sputtering target, said metal being at least one of Mo, W, Ta, Nb, Ti, V and Cr.

2.    A method according to claim 1, wherein said vacuum melting process is an EB (electron beam) melting process.

3.    A method according to claim 1, wherein said alloy is a silicide of at least one metal selected from the group consisting of Mo, W, Ta, Nb, Ti, V and Cr.

4.    A method for forming a thin film as part of a LSI chip which comprises the steps of preparing a sputtering target according to any of claims 1-3, and depositing the thin film by sputtering the sputtering target.

**Patentansprüche**

1. Verfahren zur Herstellung eines Zerstäubungstargets für einen Halbleiter, das wenigstens einen Block umfaßt, der aus einem einzelnen Metall oder einer Legierung besteht, in dem die durchschnittliche Größe der Kristallkörner 1 bis 100 μm besteht, umfassend die Stufen:

   Schmelzen des Metalles oder der Legierung durch Vakuumschmelzen;
   Abkühlen der Schmelze zur Bildung eines Schmelzbarrens;
   Schmieden, Walzen und Formen des Barrens, um ihn zu einem Target zu verformen; und
   Unterwerfen des Targets einer Rekristallisations-Wärmebehandlung, um das Zerstäubungstarget zu erhalten, wobei das Metall wenigstens eines der Metalle Mo, W, Ta, Nb, Ti, V und Cr ist.

2. Verfahren nach Anspruch 1, worin das Vakuumschmelzverfahren ein EB (Elektronenstrahl)-Schmelzverfahren ist.

3. Ein Verfahren nach Anspruch 1, worin die Legierung ein Silicid aus wenigstens einem Metall ist, ausgewählt aus der Gruppe, die aus Mo, W, Ta, Nb, Ti, V und Cr besteht.

4. Verfahren zur Bildung einer Dünnschicht als Teil eines LSI-Chips, gekennzeichnet durch die Stufen der Herstellung eines Zerstäubungstargets nach den Ansprüchen 1 bis 3, und der Abscheidung einer Dünnschicht durch Zerstäubung des Zerstäubungstargets.

**Revendications**

1. Méthode de préparation d'une cible de pulvérisation cathodique pour un semi-conducteur comprenant au moins un bloc composé d'un métal unique ou d'un alliage, dans lequel la taille moyenne des grains de cristal est de 1 à 100 μm, comprenant les étapes :

   de fusion du métal ou de l'alliage par fusion sous vide ;
   de refroidissement de la masse fondue pour former un lingot ;
   de forgeage, de roulement et de moulage du lingot pour le transformer en une cible ; et
   de soumission de la cible à un traitement thermique de recristallisation pour obtenir la cible de pulvérisation cathodique, ledit métal étant au moins l'un des éléments Mo, W, Ta, Nb, Ti, V et Cr.

2. Méthode selon la revendication 1, dans laquelle ledit processus de fusion sous vide est un processus de fusion par faisceau électronique (EB).

3. Méthode selon la revendication 1, dans laquelle ledit alliage est un siliciure d'au moins un métal choisi dans le groupe constitué de Mo, W, Ta, Nb, Ti, V et Cr.

4. Méthode de formation d'un film mince en tant que partie d'une microplaquette à circuit intégré (LSI) qui comprend les étapes de préparation d'une cible de pulvérisation cathodique selon l'une quelconque des revendications 1 à 3, et de dépôt du film mince par pulvérisation cathodique de la cible de pulvérisation cathodique.

# Fig. 1

# Fig. 2

# Fig. 3